# EUROPEAN PATENT APPLICATION

(11) **EP 4 664 763 A1**
(43) Date of publication of application: **17.12.2025**
(21) Application number: 23924897.4
(22) Date of filing: 08.09.2023
(51) Int. Cl.: H03L 7/08, G01R 19/00

(54) **POWER CONSUMPTION ADJUSTING METHOD AND APPARATUS, COMPUTING DEVICE, AND COMPUTER-READABLE STORAGE MEDIUM**

(30) Priority: 28.02.2023 CN 202310230200
(71) Applicant: Huawei Technologies Co., Ltd., Shenzhen, Guangdong 518129 (CN)
(72) Inventor: XU, Weiqiang, Shenzhen, Guangdong 518129 (CN); JIN, Ke, Shenzhen, Guangdong 518129 (CN); CHEN, Jiaxiang, Shenzhen, Guangdong 518129 (CN)
(74) Representative: Maiwald GmbH
(86) International application number: PCT/CN2023/117599
(87) International publication number: WO 2024/178942

(57) **Abstract**

A power consumption adjustment method and apparatus, a computing device, and a computer-readable storage medium are provided, and relate to the field of computer technologies, and are used to balance electric power resources. The method is applied to a power consumption control module in a computing device, and includes: obtaining monitoring results of a power supply system and a component of the computing device, where the monitoring results include a voltage drop parameter of an internal module of the component, a bus voltage drop parameter of a voltage of an input bus in the power supply system, a first bus current parameter of a current of the input bus, and a load power parameter of a core current provided for the component; determining a power control level strategy based on the monitoring results, where the power control level strategy is used to adjust power consumption of the component based on the monitoring results of the power system and the component, to cut a power peak and a dynamic power adjustment manner in the power supply system; and adjusting the power consumption of the component according to the power control level strategy.

## Description

This application claims priority to Chinese Patent Application No. CN202310230200.5, filed with the China National Intellectual Property Administration on February 28, 2023 and entitled "POWER CONSUMPTION ADJUSTMENT METHOD AND APPARATUS, COMPUTING DEVICE, AND COMPUTER-READABLE STORAGE MEDIUM", which is incorporated herein by reference in its entirety.

### TECHNICAL FIELD

This application relates to the field of computer technologies, and in particular, to a power consumption adjustment method and apparatus, a computing device, and a computer-readable storage medium.

### BACKGROUND

With the rapid development of computer technologies, a processor-based computing system with a high computing capability is widely deployed and used. Great improvement on performance and a computing capability of a chip also poses a challenge to a power supply system of a device. Therefore, how to detect a power consumption change of the device and respond to an exception becomes an urgent problem to be resolved.

In an existing power consumption adjustment method, power consumption of a device is adjusted by detecting output power consumption of a power supply module. The output power consumption of the power supply module has limited impact on the power consumption of the device. This results in unbalanced use of electric power resources.

### SUMMARY

This application provides a power consumption adjustment method and apparatus, a computing device, and a computer-readable storage medium. In the power consumption adjustment method, a power consumption state of a power supply system is determined based on an output parameter of the power supply system, and a load state of a component is also determined based on a power supply parameter of the component in a computing device; and then power consumption of the component is adjusted with reference to the power consumption state of the power supply system and the load state, to achieve an effect of balancing power consumption of the component. In other words, the power consumption of the component is adjusted by detecting a primary power supply and a secondary power supply, which can better balance electric power resources.

According to a first aspect, a power consumption adjustment method is provided, and the method is performed by a power consumption control module in a computing device. The power consumption control module may obtain monitoring results of a power supply system and a component of the computing device. The monitoring results include a voltage drop parameter of an internal module of the component, a bus voltage drop parameter of a voltage of an input bus in the power supply system, a first bus current parameter of a current of the input bus, and a load power parameter of a core current provided for the component. In other words, a type indicated by the monitoring results includes monitoring on a voltage drop and monitoring on a current, and monitoring objects corresponding to the monitoring results include the power supply system and the component. After obtaining the monitoring results, the power consumption control module determines a power control level strategy based on the monitoring results, where the power control level strategy is used to adjust power consumption of the component based on the monitoring results of the power system and the component, to cut a power peak and a dynamic power adjustment manner in the power supply system; and adjusts the power consumption of the component according to the power control level strategy.

In this application, a power consumption state of the power supply system is determined based on an output parameter of the power supply system, and a load state of the component is also determined based on a power supply parameter of the component in the computing device, and then the power consumption of the component is adjusted with reference to the power consumption state of the power supply system and the load state, to achieve an effect of balancing the power consumption of the component. In other words, the power consumption of the component is adjusted by detecting a primary power supply and a secondary power supply, which can better balance electric power resources.

In a possible implementation, the computing device includes the power supply system and the component. The power supply system indicates a series of hardware configured to supply power to the component, such as a power supply, a bus, and a voltage comparator. The component may also be referred to as an electric component or a powered component, and may be understood as a load part of the computing device.

In a possible implementation, the voltage drop parameter of the internal module of the component is obtained by an internal voltage monitoring module of the component by monitoring a voltage of the internal module of the component. In other words, a monitoring object corresponding to the voltage drop parameter of the internal module of the component is the voltage of the internal module of the component, and a monitoring subject is the internal voltage monitoring module of the component. When the voltage parameter of the internal module of the component indicates that the voltage of the internal module of the component is less than a first voltage threshold, the power consumption control module determines that the power control level strategy is reducing an operating frequency of the component to a first preset percentage of a standard operating frequency of the component. The operating frequency of the component is positively correlated with the power consumption of the component. In other words, a higher operating frequency of the component indicates higher power consumption of the component, and a lower operating frequency of the component indicates lower power consumption of the component. In this case, that the power consumption control module adjusts the power consumption of the component according to the power control level strategy means that the power consumption control module controls the operating frequency of the component to be reduced to the first preset percentage of the standard operating frequency of the component, to reduce the power consumption of the component. The first preset percentage may be determined based on experimental data and service performance, and the service performance is considered in a balanced manner, to avoid a case in which a reduction in the operating frequency of the component causes great deterioration of the service performance, so that the service can still be normally performed.

In a possible implementation, the bus voltage drop parameter is obtained by a bus voltage monitoring module on the input bus in the power supply system by monitoring the voltage of the input bus in the power supply system. In other words, a monitoring object of the bus voltage drop parameter is the voltage of the input bus, and a monitoring subject is the bus voltage monitoring module on the input bus. When the bus voltage drop parameter indicates that the voltage of the input bus in the power supply system is less than a second voltage threshold, the power consumption control module determines that the power control level strategy is reducing the operating frequency of the component to a second preset percentage of a current operating frequency of the component. In this case, that the power consumption control module adjusts the power consumption of the component according to the power control level strategy means that the power consumption control module controls the operating frequency of the component to be reduced to the second preset percentage of the standard operating frequency of the component, to reduce the power consumption of the component. The second preset percentage may be determined based on the experimental data and the service performance, and the service performance is considered in a balanced manner, to avoid a case in which a reduction in the operating frequency of the component causes great deterioration of the service performance, so that the service can still be normally performed.

In this application, the voltage drop monitoring not only includes voltage drop monitoring on the internal module of the component, but also includes voltage drop monitoring on the input bus. This implements multi-level detection on a voltage drop of the computing device. In this way, detection is more comprehensive, and practicability of the technical solutions of this application is also improved. In addition, the power consumption control performed based on the monitoring results indicating the voltage drop parameter is implemented based on the hardware. Specifically, the operating frequency of the component is reduced to a preset percentage, so that fast peak cutting can be implemented.

In a possible implementation, the load power parameter is obtained by a power control chip by detecting the core current of the component. In other words, a monitoring object of the load power parameter is the core current of the component, and a monitoring subject is the power control chip. When the load power parameter indicates that the core current of the component is greater than a first current threshold, the power consumption control module determines that the power control level strategy is reducing the operating frequency of the component to a third preset percentage of the standard operating frequency of the component. In this case, that the power consumption control module adjusts the power consumption of the component according to the power control level strategy means that the power consumption control module controls the operating frequency of the component to be reduced to the third preset percentage of the standard operating frequency of the component, to reduce the power consumption of the component. The third preset percentage may be determined based on the experimental data and the service performance, and the service performance is considered in a balanced manner, to avoid a case in which a reduction in the operating frequency of the component causes great deterioration of the service performance, so that the service can still be normally performed.

In a possible implementation, the first bus current parameter is obtained by a bus current detection module on the input bus in the power supply system by monitoring the current of the input bus. In other words, a monitoring object of the first bus current parameter is the current of the input bus, and a monitoring subject is the bus current detection module on the input bus. When the first bus current parameter indicates that the current of the input bus is greater than a second current threshold, the power consumption control module determines that the power control level strategy includes a hardware control strategy, and the hardware control strategy indicates to reduce the operating frequency of the component to a fourth preset percentage of the standard operating frequency of the component. In this case, that the power consumption control module adjusts the power consumption of the component according to the power control level strategy means that the power consumption control module controls the operating frequency of the component to be reduced to the fourth preset percentage of the standard operating frequency of the component, to reduce the power consumption of the component. The fourth preset percentage may be determined based on the experimental data and the service performance, and the service performance is considered in a balanced manner, to avoid a case in which a reduction in the operating frequency of the component causes great deterioration of the service performance, so that the service can still be normally performed.

In this application, the current monitoring not only includes current monitoring on the internal module of the component, but also current monitoring on the input bus. This implements multi-level detection on a current of the computing device. In this way, detection is more comprehensive, and practicability of the technical solutions of this application is also improved. In addition, a current parameter is monitored by using the hardware and performing the power consumption control based on the monitoring results is implemented based on the hardware. Specifically, the operating frequency of the component is reduced to a preset percentage, so that fast peak cutting can be implemented.

In a possible implementation, after the power consumption of the component is adjusted according to the power control level strategy, the power consumption control module further continuously obtains a monitoring result of the current of the input bus, to perform more refined processing. In other words, the power consumption control module obtains a second bus current parameter of the current of the input bus, where the second bus current parameter is obtained by a software module by querying the current of the input bus. When the second bus current parameter indicates that the current of the input bus is greater than a third current threshold, and the power consumption control module enters a software control phase, the power consumption control module determines a first frequency reduction amplitude and a first voltage reduction amplitude based on the second bus current parameter. That the power consumption control module enters a software phase means that time in which the current of the input bus is greater than the third current threshold reaches response time of the software module. The first frequency reduction amplitude indicates a percentage of the standard operating frequency of the component to which the operating frequency of the component is to be reduced, and the first voltage reduction amplitude indicates a percentage of a current voltage to which a voltage of the component is to be reduced. In addition, the operating frequency and the voltage of the component are controlled to be reduced based on the first frequency reduction amplitude and the first voltage reduction amplitude, to reduce the power consumption of the component. There is a correspondence between the first frequency reduction amplitude and the first voltage reduction amplitude. Specifically, an operating frequency of the component adjusted based on the first frequency reduction amplitude corresponds to a voltage of the component adjusted based on the first voltage reduction amplitude, and the correspondence is usually set before delivery of the component.

In this application, after fast peak cutting is performed on the power consumption of the component, the current of the input bus is further detected and continuously monitored in real time, to implement refined processing. In conclusion, in the technical solutions of this application, when the power consumption control is performed, the operating frequency of the component is reduced based on the preset percentage, and may be reduced based on a percentage that is determined in real time. This can implement fast peak cutting and refined processing, further enriches application scenarios and implementations of the technical solutions of this application, and improves implementability of the technical solutions.

In a possible implementation, the first bus current parameter is obtained by the software module by querying the current of the input bus. When the first bus current parameter indicates that the current of the input bus is greater than a third current threshold, and the power consumption control module enters a software control phase, the power consumption control module determines a second frequency reduction amplitude and a second voltage reduction amplitude based on the first bus current parameter. That the power consumption control module enters a software phase means that time in which the current of the input bus is greater than the third current threshold reaches response time of the software module. The second frequency reduction amplitude indicates a percentage of the standard operating frequency of the component to which the operating frequency of the component is to be reduced, and the second voltage reduction amplitude indicates a percentage of a current voltage to which the voltage of the component is to be reduced. In addition, the operating frequency and the voltage of the component are controlled to be reduced based on the second frequency reduction amplitude and the second voltage reduction amplitude, to reduce the power consumption of the component. There is a correspondence between the second frequency reduction amplitude and the second voltage reduction amplitude. Specifically, an operating frequency of the component adjusted based on the second frequency reduction amplitude corresponds to a voltage of the component adjusted based on the second voltage reduction amplitude, and the correspondence is usually set before delivery of the component.

In this application, the second frequency reduction amplitude and the second voltage reduction amplitude are determined based on the first bus current parameter that is monitored in real time, so that the current of the input bus is reduced to below a third threshold. The real-time determining manner can implement refined processing, and further enrich application scenarios and implementations of the technical solutions of this application.

In a possible implementation, after the adjusting the power consumption of the component according to the power control level strategy, the method further includes: If the current of the input bus is continuously less than a fourth current threshold within preset duration, the power consumption control module controls the power consumption of the component to restore to power consumption before the reduction. The fourth current threshold is less than or equal to the third current threshold.

In this application, adjustment of the power consumption of the component includes power consumption reduction and power consumption restoration. This ensures normal operation of the component in the computing device from a plurality of aspects, and further improves practicability of the technical solutions.

According to a second aspect, this application provides a power consumption control apparatus, where the power consumption control apparatus includes modules configured to perform the data processing method according to any one of the first aspect or the possible implementations of the first aspect.

According to a third aspect, a computing device is provided, including a power consumption monitoring circuit, a control module, and a power supply circuit.

The power supply circuit supplies power to the power consumption monitoring circuit and the control module.

The power consumption monitoring circuit is configured to: monitor a power supply system and a component of the computing device; and transmit monitoring results of the power supply system and the component to the control module, where the monitoring results include a voltage drop parameter of an internal module of the component, a bus voltage drop parameter of a voltage of an input bus in the power supply system, a first bus current parameter of a current of the input bus, and a load power parameter of a core current provided for the component.

The control module is configured to: determine a power control level strategy based on the monitoring results, where the power control level strategy is used to adjust power consumption of the component based on the monitoring results of the power system and the component, to cut a power peak and a dynamic power adjustment manner in the power supply system; and adjust the power consumption of the component according to the power control level strategy. The method according to any one of the first aspect and the possible implementations of the first aspect can be implemented.

According to a fourth aspect, a computer-readable storage medium is provided. The computer-readable storage medium stores instructions, and when the instructions are run on a processor, the method according to any one of the first aspect and the possible implementations of the first aspect is implemented.

According to a fifth aspect, a computer program product is provided. When the computer program product is executed on a processor, the method according to any one of the first aspect and the possible implementations of the first aspect is implemented.

Beneficial effects shown in the second aspect to the fifth aspect are similar to those of the first aspect and any possible implementation of the first aspect. Details are not described herein again.

In this application, based on the implementations according to the foregoing aspects, the implementations may be further combined to provide more implementations.

### BRIEF DESCRIPTION OF DRAWINGS

FIG. 1 is a diagram of a system architecture according to this application;
FIG. 2 is a schematic flowchart of a power consumption adjustment method according to this application;
FIG. 3 is a diagram of a power consumption adjustment method according to this application;
FIG. 4 is another schematic flowchart of a power consumption adjustment method according to this application;
FIG. 5 is another diagram of a power consumption adjustment method according to this application;
FIG. 6 is a diagram of a structure of a power consumption control apparatus according to this application;
FIG. 7 is a diagram of a structure of a computing device according to this application;
FIG. 8 is another diagram of a structure of a computing device according to this application; and
FIG. 9 is a diagram of a structure of a chip according to this application.

### DESCRIPTION OF EMBODIMENTS

For ease of understanding, proper nouns and related concepts that may be used in this application are first described.

**Primary power supply:** The primary power supply is also referred to as a first-stage power supply, and refers to converting an external alternating current into a direct current that is input to a board. It should be noted that, in an ideal state, the primary power supply, serving as a power conversion module, converts an alternating current into a standard direct current. However, during actual application, due to a change of load power consumption, a line loss, and the like, a voltage of the direct current obtained through the conversion performed by the primary power supply fluctuates. Consequently, an output of the power conversion module is affected.

**Secondary power supply:** The secondary power supply is also referred to as a second-stage power supply, and refers to converting a direct current that is input to a board into a voltage needed for a post-stage circuit.

To resolve a problem of unbalanced use of electric power resources, this application provides a power consumption adjustment method. A power consumption control module may determine a power control level strategy based on monitoring results of a power supply system and a component. The power level strategy is used to adjust power consumption of the component, to cut a power peak and dynamically adjust power in the power supply system. This achieves an effect of balancing power consumption. In other words, in comparison with a conventional solution in which only a power supply system is monitored, the power consumption of the component is adjusted by monitoring the primary power supply and the secondary power supply, which can better balance electric power resources.

The following describes in detail the power consumption adjustment method provided in this application with reference to the accompanying drawings.

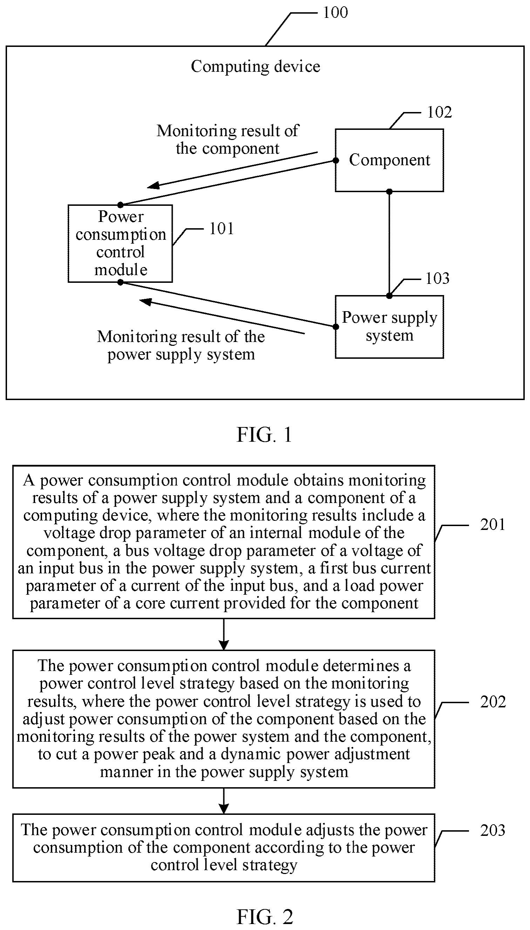

FIG. 1 is a diagram of a system architecture according to this application. As shown in FIG. 1, a computing device 100 includes a power consumption control module 101, a component 102, and a power supply system 103. The component 102 and the power consumption control module 101 may also be understood as a load part of the computing device 100. The power supply system 103 is configured to supply power to the component 102, and includes a series of components that are configured to supply power to the component, such as a power conversion module, a bus, and a voltage controller. For example, the power supply system 103 may implement a process of converting an external alternating current to a direct current needed by the computing device 100, and provide working electric power for the component 102 in the computing device 100.

In this application, the power consumption control module 101 can obtain an electric power condition of the computing device 100, and adjust power consumption of the component 102 in a timely manner. Specifically, the power consumption control module 101 obtains a monitoring result of the component 102 and a monitoring result of the power supply system 103. Specific content of the monitoring results and a power consumption adjustment process are described in detail in the following, and details are not described herein again.

It should be noted that the power consumption control module 101 includes a hardware entity that is in the computing device 100 and that is configured to adjust the power consumption of the component 102, and also includes a software product that implements these functions, or a combination of a software product and a hardware entity. This is not specifically limited herein. The power consumption control module 101 may be implemented by using a plurality of components, for example, a voltage comparator, a current comparator, a digital-to-analog conversion (analog-digital converter, ADC) sampler, and a control module. In conclusion, this application may cover heavy load scenarios in various time specifications, and system power consumption is controlled within a power supply capability range of a power supply by using a method of combining software and hardware. The heavy load scenario includes an artificial intelligence (artificial intelligence, AI) service scenario or another service scenario in which instantaneous power consumption changes greatly. This is not specifically limited herein.

In addition, the computing device 100 may also have a plurality of possibilities, and may include a host, a server, or another terminal device. A terminal includes various handheld devices, vehicle-mounted devices, wearable devices, or another processing device connected to a wireless modem that have a wireless communication function. This is not specifically limited herein.

The power consumption adjustment method provided in this application may be applied to the architecture described above. The following provides detailed descriptions with reference to a diagram. FIG. 2 is a schematic flowchart of a power consumption adjustment method according to this application. The method includes at least the following steps.

Step 201: A power consumption control module obtains monitoring results of a power supply system and a component of a computing device, where the monitoring results include a voltage drop parameter of an internal module of the component, a bus voltage drop parameter of a voltage of an input bus in the power supply system, a bus current parameter of a current of the input bus, and a load power parameter of a core current provided for the component.

The monitoring result of the power supply system indicates a result of monitoring an electric power condition of the power supply system. The power supply system herein includes a series of hardware configured to supply power to the component, such as a power supply, a bus, and a voltage controller. The monitoring result of the component indicates a result of monitoring an electric power condition of the component. The component may also be understood as a load part of the computing device, and is a power supplied object of the power supply system. The monitoring results include different parameters, which are obtained by different monitoring subjects by monitoring different monitoring objects and then transmitted to the power consumption control module. The following describes different parameters.

Simply, monitoring types, monitoring objects, and monitoring subjects corresponding to the monitoring results may be shown in Table 1.

**Table 1**

| Type | Monitoring object | Monitoring subject |
|---|---|---|
| Voltage drop monitoring | Voltage of the internal module of the component | Internal voltage monitoring module of the component |
| | Voltage of the input bus | Bus voltage monitoring module |
| Current monitoring | Core current of the component | Power control chip |
| | Current of the input bus | Bus current detection module |
| | | Software module |

As shown in Table 1, monitoring on the electric power conditions of the power supply system and the component may be classified into different types of monitoring: the voltage drop monitoring and the current monitoring. Monitoring objects corresponding to the voltage drop monitoring include the voltage of the internal module of the component and the voltage of the input bus, and the voltage of the internal module of the component and the voltage of the input bus are respectively monitored by the internal voltage monitoring module of the component and the bus voltage monitoring module that serve as monitoring subjects. Monitoring objects corresponding to the current monitoring include the core current of the component and the current of the input bus. The core current of the component is monitored by the power control chip that serves as a monitoring subject. The current of the input bus has a plurality of monitoring subjects, where the monitoring subjects include the bus current detection module and the software module. The following describes the parameters in detail.

The voltage drop parameter of the internal module of the component is obtained by the internal voltage monitoring module of the component by monitoring the voltage of the internal module of the component. The voltage drop parameter of the internal module of the component can indicate a change of the voltage of the internal module of the component, in other words, not only includes a voltage of the internal module of the component before the change and a voltage of the internal module of the component after the change, but also can indicate a voltage drop condition of the internal module of the component. The internal voltage monitoring module of the component includes an ADC sampler, a critical path monitor (critical path monitor, CPM) module, and the like. This is not specifically limited herein. For example, assuming that the component is a chip, an internal critical path voltage of the chip may be detected via a built-in critical path monitoring module of the chip. Because the chip may have a plurality of access voltages, the critical path voltage herein is a voltage provided by the power supply system for the chip.

The bus voltage drop parameter is obtained by the bus voltage monitoring module on the input bus in the power supply system by monitoring the voltage of the input bus in the power supply system. The bus voltage drop parameter can indicate a change of the voltage of the input bus, in other words, not only includes a bus voltage before the change and a bus voltage after the change, but also can indicate a voltage drop condition of the input bus. The voltage of the input bus herein is a voltage output by the power supply system before direct current-to-direct current (direct current to direct current, DC/DC) conversion.

The load power parameter is obtained by the power control chip by monitoring the core current of the component. The core current herein is a current provided by the power supply system for the component. The power supply control chip includes a chip that can monitor the core current of the component, for example, a multiphase power supply controller. This is not specifically limited herein. For example, assuming that the component is an artificial intelligence core (artificial intelligence core, AI core)-type component, the core current is a core current of an AI core.

A first bus current parameter is obtained by monitoring the current of the input bus. The current of the input bus herein is a current output by the power supply system before DC/DC conversion. However, there are a plurality of possible monitoring subjects of the current of the input bus, which are described as follows.

In some optional implementations, the first bus current parameter is obtained by the bus current detection module on the input bus in the power supply system by monitoring the current of the input bus. The bus current detection module includes hardware that is located on the input bus and that has a capability of monitoring the current of the input bus, such as an ADC chip. The ADC chip is used as an example. The first bus current parameter includes a parameter of a sampled bus current flowing through the ADC chip.

In some optional implementations, the first bus current parameter is obtained by the software module by querying the current of the input bus. It may be understood that, to query the current of the input bus, the software module needs to exchange information with hardware that monitors the current of the input bus. Therefore, time for the software module to obtain a first bus current parameter is greater than time for the bus current detection module to obtain the first bus current parameter.

Step 202: The power consumption control module determines a power control level strategy based on the monitoring results, where the power control level strategy is used to adjust power consumption of the component based on the monitoring results of the power system and the component, to cut a power peak and a dynamic power adjustment manner in the power supply system.

As described in step 201, the monitoring results of the power supply system and the component include parameters in a plurality of aspects. When determining the power control level strategy based on the monitoring results, the power consumption control module determines strategies of different content based on different parameters.

With reference to Table 2, the following briefly describes the determining a power control level strategy based on the monitoring results.

**Table 2**

| Type | Control phase | Monitoring object | Threshold | Threshold example |
|---|---|---|---|---|
| Voltage drop monitoring | Control the internal module of the component | Voltage of the internal module of the component | First voltage threshold | 0.95×V |
| | Control an input bus voltage drop | Voltage of the input bus | Second voltage threshold | 0.9×Vbus |
| Current monitoring | Control a component power | Core current of the component | First current threshold | 2.1×TDC |
| | Hardware controlling on the input bus | Current of the input bus | Second current threshold | 1.5×TDC |
| | Software controlling on the input bus | | Third current threshold (less than the second current threshold) | 1.2×TDC |

As shown in Table 2, the monitoring results correspond to different monitoring objects. When the monitoring objects reach corresponding thresholds, control phases of different levels are triggered, in other words, the monitoring objects correspond to different power level control strategies. In addition, it should be noted that the threshold example shown in Table 2 is merely an example of a threshold corresponding to each monitoring object, and do not constitute a limitation on a threshold during actual application. V and Vbus respectively represent the voltage of the internal module of the component and the voltage of the input bus, and TDC represents a thermal design current (thermal design current).

With reference to Table 2, it can be learned that, in this application, the voltage drop monitoring not only includes voltage drop monitoring on the internal module of the component, but also includes voltage drop monitoring on the input bus. This implements multi-level detection on a voltage drop of the computing device. The current parameter monitoring not only includes current monitoring on the internal module of the component, but also current monitoring on the input bus. This implements multi-level detection on a current of the computing device. In other words, in this application, detection is more comprehensive, and practicability of the technical solutions of this application is also improved.

With reference to the accompanying drawings, the following describes in detail a process of determining the power level control strategy. First, solutions corresponding to the voltage drop monitoring are described. The Monitoring objects corresponding to the voltage drop monitoring include the voltage of the internal module of the component and the voltage of the input bus. Descriptions are separately provided in the following.

In some optional implementations, if a voltage parameter of the internal module of the component indicates that the voltage of the internal module of the component is less than the first voltage threshold, a phase of controlling the internal module of the component is triggered, in other words, the power consumption control module determines that the power control level strategy is reducing an operating frequency of the component to a first preset percentage of a standard operating frequency of the component. The operating frequency of the component is positively correlated with the power consumption of the component. In other words, a higher operating frequency of the component indicates higher power consumption of the component, and a lower operating frequency of the component indicates lower power consumption of the component.

The first voltage threshold may be determined based on a voltage at which the component operates normally. Usually, the first voltage threshold is less than or equal to a minimum voltage at which the component operates normally. Because the voltage usually fluctuates in an operating process of the component, a fluctuation range of the voltage is also considered when the minimum voltage at which the component operates normally is determined. The first preset percentage may be determined based on experimental data and service performance. Because the operating frequency of the component is also positively correlated with performance of the component, a reduction in the operating frequency causes deterioration of the performance of the component. This affects the service performance. Therefore, when the first preset percentage is set, the service performance is considered in a balanced manner, to avoid a case in which the reduction in the operating frequency of the component causes great deterioration of the service performance, so that the service can still be normally performed. Optionally, during actual application, the first preset percentage may be usually set to be greater than or equal to 80%.

In some optional implementations, if the bus voltage drop parameter indicates that the voltage of the input bus in the power supply system is less than the second voltage threshold, a phase of controlling an input bus drop voltage is triggered, in other words, the power consumption control module determines that the power control level strategy is reducing the operating frequency of the component to a second preset percentage of a current operating frequency of the component.

The second voltage threshold may be determined based on a voltage at which the power supply system operates normally. Usually, the second voltage threshold is less than or equal to a minimum voltage at which the power supply system operates normally. In an operating process of the computing device, a voltage of a load often fluctuates, which also affects the voltage of the input bus in the power supply system. Therefore, when the minimum voltage at which the power supply system operates normally is determined, a fluctuation range of the voltage is also considered. Similar to the first preset percentage, the second preset percentage may also be determined based on the experimental data and the service performance, and impact of the operating frequency of the component on the service performance is comprehensively considered. During actual application, the second preset percentage may be usually set to be greater than or equal to 80%.

In the foregoing optional implementation, the solutions corresponding to the voltage drop monitoring are described. The following describes solutions corresponding to the current monitoring. The Monitoring objects corresponding to the current monitoring include the core current of the component and the current of the input bus. Descriptions are separately provided in the following.

In some optional implementations, if the load power parameter indicates that the core current of the component is greater than the first current threshold, a phase of controlling a component power is triggered, in other words, the power consumption control module determines that the power control level strategy is reducing the operating frequency of the component to a third preset percentage of the standard operating frequency of the component. The first current threshold may be determined based on a current at which the component operates normally. Usually, the first current threshold is greater than or equal to a maximum current at which the component operates normally. Because the current usually fluctuates in the operating process of the component, a fluctuation range of the voltage is also considered when the maximum current at which the component operates normally is determined. Similar to the first preset percentage, the third preset percentage may also be determined based on the experimental data and the service performance, and the impact of the operating frequency of the component on the service performance is comprehensively considered. During actual application, the third preset percentage may be usually set to be greater than or equal to 80%.

In some optional implementations, if the first bus current parameter indicates that the current of the input bus is greater than the second current threshold, a phase of hardware controlling on the input bus is triggered, in other words, the power consumption control module determines that the power control level strategy includes a hardware control strategy, and the hardware control strategy indicates to reduce the operating frequency of the component to a fourth preset percentage of the standard operating frequency of the component. The second current threshold may be determined based on a current at which the power supply system operates normally. Usually, the second current threshold is greater than or equal to a maximum current at which the power supply system operates normally. In the operating process of the computing device, a current of the load often fluctuates, which also affects the current of the input bus in the power supply system. Therefore, when the maximum current at which the power supply system operates normally is determined, a fluctuation range of the current is also considered. Similar to the first preset percentage, the fourth preset percentage may also be determined based on the experimental data and the service performance, and the impact of the operating frequency of the component on the service performance is comprehensively considered. During actual application, the fourth preset percentage may be usually set to be greater than or equal to 80%.

In some optional implementations, if the first bus current parameter indicates that the current of the input bus is greater than the third current threshold, and the power consumption control module enters a software control phase, the power consumption control module determines that the power control level strategy includes a software control strategy. In other words, the power consumption control module determines a second frequency reduction amplitude and a second voltage reduction amplitude based on the first bus current parameter. That the power consumption control module enters a software control phase means that time in which the first bus current parameter indicates that the current of the input bus is greater than the third current threshold reaches response time of the software module. The response time of the software module is usually greater than or equal to 50 ms. This is not specifically limited herein.

The second frequency reduction amplitude indicates a percentage of the standard operating frequency of the component to which the operating frequency of the component is to be reduced, and the second voltage reduction amplitude indicates a percentage of a current voltage to which the voltage of the component is to be reduced. In addition, there is a correspondence between the second frequency reduction amplitude and the second voltage reduction amplitude. Specifically, an operating frequency of the component adjusted based on the second frequency reduction amplitude corresponds to a voltage of the component adjusted based on the second voltage reduction amplitude, and the correspondence is usually set before delivery of the component. For example, it is assumed that the component defines a case in which a voltage corresponding to a component whose operating frequency is 1 GHz is about 0.9 V, and a fluctuation range of the voltage may be ±2% to ±5%. If the operating frequency of the component adjusted based on the second frequency reduction amplitude is 1 GHz, the voltage of the component adjusted based on the second voltage reduction amplitude needs to be about 0.9 V.

The third current threshold may be determined based on the current at which the power supply system operates normally. Usually, the third current threshold is greater than or equal to the maximum current at which the power supply system operates normally. In addition, the third current threshold is less than the second current threshold.

The percentage indicated by the second frequency reduction amplitude is determined based on the first bus current parameter and ensuring that the current of the input bus can be reduced to the third current threshold, to ensure that load power consumption is controlled within a power supply capability of the power supply system.

It should be noted that, in the foregoing implementations, how to determine the power level control strategy when a monitoring object in the voltage drop monitoring or the current monitoring reaches a threshold is described. During actual application, a plurality of monitoring objects may simultaneously reach their respective corresponding thresholds at a current moment, in other words, a plurality of power level control strategies are triggered by a power peak. In this case, the power level control strategy determined by the power consumption control module needs to be capable of cutting the power peak. In other words, the power level control strategy determined by the power consumption control module indicates that the operating frequency of the component should be reduced to a minimum operating frequency of a plurality of operating frequencies corresponding to a plurality of monitoring objects that reach respective corresponding thresholds. In addition, if the voltage of the component needs to be reduced, the power level control strategy determined by the power consumption control module should also include reducing the voltage.

For example, it is assumed that at a current moment, the voltage parameter of the internal module of the component indicates that the voltage of the internal module of the component is less than the first voltage threshold, and the bus voltage drop parameter indicates that the voltage of the input bus in the power supply system is less than the second voltage threshold. In this case, the power level control strategy determined by the power consumption control module should indicate that the operating frequency of the component should be reduced to a lower preset percentage in a first preset percentage and the second preset percentage of the current operating frequency.

For example, it is assumed that at a current moment, the voltage parameter of the internal module of the component indicates that the voltage of the internal module of the component is less than the first voltage threshold, and the first bus current parameter indicates that the current of the input bus is greater than the third current threshold, and the power consumption control module enters the software control phase. In this case, the power level control strategy determined by the power consumption control module indicates that the operating frequency of the component should be reduced to a lower percentage in the first preset percentage of the standard operating frequency and the percentage corresponding to the second frequency reduction amplitude determined based on the first bus current parameter. In addition, the power level control strategy further needs to indicate a voltage reduction amplitude determined based on the first bus current parameter.

Step 203: The power consumption control module adjusts the power consumption of the component according to the power control level strategy.

As described in step 202, when determining the power control level strategy based on the monitoring results, the power consumption control module determines power control level strategies of different content based on different parameters included in the monitoring results. Therefore, when the power consumption control module adjusts the power consumption of the component according to the power control level strategy, the power consumption of the component is also different. The following provides brief descriptions with reference to Table 3.

**Table 3**

| Type | Control phase | Monitoring object | Threshold | Power control level strategy |
|---|---|---|---|---|
| Voltage drop monitoring | Control the internal module of the component | Voltage of the internal module of the component | First voltage threshold | Reduce a frequency to a first preset percentage |
| | Control the input bus voltage drop | Voltage of the input bus | Second voltage threshold | Reduce a frequency to a second preset percentage |
| Current monitoring | Control the component power | Core current of the component | First current threshold | Reduce a frequency to a third preset percentage |
| | Hardware controlling on the input | Current of the input bus | Second current threshold | Reduce a frequency to a fourth preset percentage |
| | bus | | | |
| | Software controlling on the input bus | | Third current threshold (less than the second current threshold) | Determine the second frequency reduction amplitude and the second voltage reduction amplitude in real time |

It should be noted that "reduce a frequency to XX preset percentage" in the "power control level strategy " shown in Table 3 means that the operating frequency of the component is reduced to XX preset percentage of the standard operating frequency of the component. In addition, as shown in Table 3, frequency reduction amplitudes of the component corresponding to different power control level strategies are different, and correspondingly, power consumption of the component adjusted according to the power control level strategy is also different. Descriptions are separately provided in the following.

In some optional implementations, a scenario in a first row in Table 3 is used as an example. The power control level strategy is reducing the operating frequency of the component to the first preset percentage of the standard operating frequency of the component. In this case, that the power consumption control module adjusts the power consumption of the component according to the power control level strategy is controlling the operating frequency of the component to be reduced to the first preset percentage of the standard operating frequency of the component, to reduce the power consumption of the component. A reason why the power consumption of the component can be reduced by reducing the operating frequency of the component is that the operating frequency of the component is positively correlated with the power consumption of the component. In other words, a lower operating frequency of the component indicates lower power consumption of the component.

Similarly, a process of adjusting the power consumption of the component according to the power control level strategy that is represented by a second row to a fourth row in Table 3 is similar to the foregoing scenario represented by the first row in Table 3, except that amplitudes by which the operating frequency of the component is controlled to be reduced are not the first preset percentage, but are the second preset percentage, the third preset percentage, and the fourth preset percentage respectively. Therefore, details are not described herein again.

In some optional implementations, a scenario in a fifth row in Table 3 is used as an example. If the power control level strategy is determining the second frequency reduction amplitude and the second voltage reduction amplitude based on a computing capability of the component and a service performance, that the power consumption control module adjusts the power consumption of the component according to the power control level strategy is controlling the operating frequency of the component to be reduced based on the second frequency reduction amplitude, and controlling the voltage of the component to be reduced based on the second voltage reduction amplitude, to reduce the power consumption of the component.

It can be learned from the foregoing descriptions that, the scenario shown in the fifth row in Table 3 is slightly different from the adjusting the power consumption of the component according to the power control level strategy in the foregoing several scenarios: (1) In the scenario shown in the fifth row in Table 3, the operating frequency of the component is controlled to be reduced, and the voltage of the component is also controlled to be reduced. In the foregoing several scenarios, the power consumption control module only controls the operating frequency of the component to be reduced. (2) In the scenario shown in the fifth row in Table 3, the second frequency reduction amplitude is determined based on a first bus current parameter that is obtained in real time, and the operating frequency of the component is not reduced based on a preset percentage. In the foregoing several scenarios, the operating frequency of the component is reduced based on a preset percentage.

It should be noted that, the control phases shown in the first four rows in Table 3 may be understood as being implemented based on hardware monitoring, and specifically, the operating frequency of the component is reduced to the preset percentage, so that fast peak cutting can be implemented. The hardware herein includes a voltage comparator, a current comparator, an ADC sampler, a CPM module, and the like. This is not specifically limited herein. The ADC sampler or the CPM module is configured to collect a voltage or a current, the voltage comparator is configured to compare a monitored voltage with a corresponding voltage threshold, and the current comparator is configured to compare a monitored current with a corresponding current threshold. The control phase shown in the fifth row may be understood as being implemented based on software. The software module continuously obtains the current of the input bus from the ADC sampler for a plurality of times. The second frequency reduction amplitude and the second voltage reduction amplitude that are determined based on the software are determined based on the first bus current parameter that is obtained in real time, so that refined processing can be implemented, and application scenarios and implementations of the technical solutions of this application are further enriched.

In this application, the power consumption control module may determine the power control level strategy based on the monitoring results of the power supply system and the component. The power level strategy is used to adjust the power consumption of the component, to cut the power peak and dynamically adjust power in the power supply system. This achieves an effect of balancing power consumption. In other words, in comparison with a conventional solution in which only a power supply system is monitored, the power consumption of the component is adjusted by monitoring a primary power supply and a secondary power supply, which can better balance electric power resources.

In some optional implementations, after step 203, the power consumption control module may further obtain a second bus current parameter of the current of the input bus, where the second bus current parameter is obtained by the software module by monitoring the current of the input bus. In other words, the software module continuously monitors the current of the input bus. After execution at the hardware control phase is completed, if the second bus current parameter indicates that the current of the input bus is greater than the third current threshold, and the power consumption control module enters the software control phase (in other words, the time in which the current of the input bus is greater than the third current threshold reaches the response time of the software module), it indicates that after the power consumption control module controls the operating frequency of the component to be reduced to the fourth preset percentage of the standard operating frequency of the component, although a function of cutting the power peak is achieved, an ideal state is not achieved. In other words, the power consumption of the component needs to be further controlled.

In this case, the power consumption control module determines a first frequency reduction amplitude and a first voltage amplitude based on the second bus current parameter. The first frequency reduction amplitude indicates a percentage of the standard operating frequency of the component to which the operating frequency of the component is to be reduced, and the first voltage reduction amplitude indicates a percentage of the current voltage to which the voltage of the component is to be reduced. Then, the power consumption control module controls, based on the first frequency reduction amplitude and the first voltage reduction amplitude, the operating frequency and the voltage of the component to be reduced, to reduce the power consumption of the component.

It should be noted that there is also a correspondence between the first frequency reduction amplitude and the first voltage reduction amplitude. Specifically, an operating frequency of the component adjusted based on the first frequency reduction amplitude corresponds to a voltage of the component adjusted based on the first voltage reduction amplitude, and the correspondence is usually set before delivery of the component. Specifically, this is similar to the foregoing related descriptions of "there is a correspondence between the second frequency reduction amplitude and the second voltage reduction amplitude". Details are not described herein again.

In this application, after fast peak cutting is performed on the power consumption of the component, the current of the input bus is further detected and continuously monitored in real time, to implement refined processing. In conclusion, in the technical solutions of this application, when power consumption control is performed, the operating frequency of the component is reduced based on the preset percentage, and may be reduced based on a percentage that is determined in real time. This can implement fast peak cutting and refined processing, further enriches application scenarios and implementations of the technical solutions of this application, and improves implementability of the technical solutions.

In addition, it should be noted that, in this application, when a current parameter is a transient high threshold (to be specific, a corresponding first current threshold or second current threshold is reached in a short period of time), the hardware control phase is triggered, to implement fast response. When the current parameter indicates that the current of the input bus exceeds the third current threshold for a long period of time, the software control phase is entered. The short period of time herein is response time of the hardware, and is usually at a microsecond level or a millisecond level. This is not specifically limited herein. The long period of time is response time of the software module, and is greater than the response time of the hardware, and is usually at a millisecond level. This is not specifically limited herein. In other words, the power consumption adjustment method provided in this application can implement a multi-level time specification response.

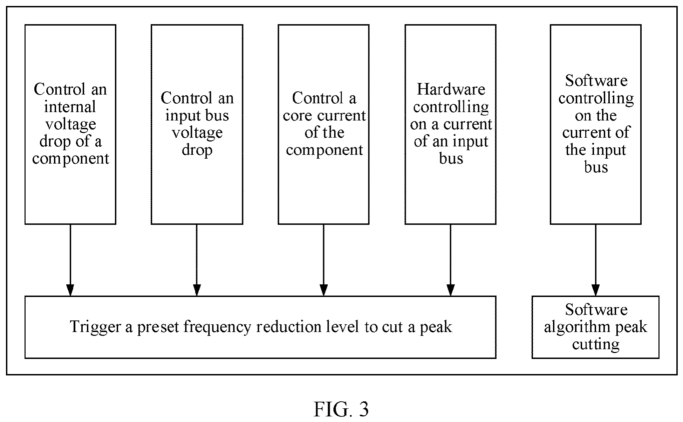

The foregoing describes, with reference to FIG. 2, the power consumption adjustment method provided in this application. The following further describes, with reference to FIG. 3 to FIG. 5, the power consumption adjustment method provided in this application.

First, with reference to FIG. 3, a level in the power control level strategy mentioned in the foregoing power consumption adjustment method is described.

As shown in FIG. 3, the power consumption adjustment method provided in this application may be divided into five levels, including: controlling an internal voltage drop of a component, controlling an input bus voltage drop, controlling a core current of the component, hardware controlling on a current of an input bus, and software controlling on the current of the input bus.

Controlling the internal voltage drop of the component corresponds to the scenario in the first row in Table 1 to Table 3, controlling the input bus voltage drop corresponds to the scenario in the second row in Table 1 to Table 3, controlling the core current of the component corresponds to the scenario in the third row in Table 1 to Table 3, hardware controlling on the current of the input bus corresponds to the scenario in the fourth row in Table 1 to Table 3, and software controlling on the current of the input bus corresponds to the scenario in the fifth row in Table 1 to Table 3.

As described in the foregoing related descriptions in step 203, the first four scenarios may be understood as being implemented based on hardware monitoring, and a preset level of frequency reduction is triggered to cut a peak, in other words, an operating frequency of the component is reduced based on a preset percentage. The fifth scenario is implemented based on software, including: A software module continuously obtains a current of an input bus from an ADC sampler for a plurality of times, and performs calculation based on the current of the input bus. In this case, when power consumption of the component needs to be reduced (in other words, a quantity of times that a power supply current of the component exceeds a third current threshold within first preset duration is greater than a preset quantity of times), a frequency reduction amplitude and a voltage reduction amplitude of the component are determined by using a software algorithm.

In conclusion, in a hardware-based implementation process, when the power consumption of the component is reduced, a reduction in the operating frequency of the component may be triggered, to reduce the power consumption of the component. Usually, time for performing the foregoing process is at a millisecond level, and a response speed is faster. However, in a software-based implementation process, because a specific value of the current of the input bus needs to be obtained for the plurality of times, and then the frequency reduction amplitude and the voltage reduction amplitude of the component are calculated and determined. Specific operation time is needed. In this case, response time is longer.

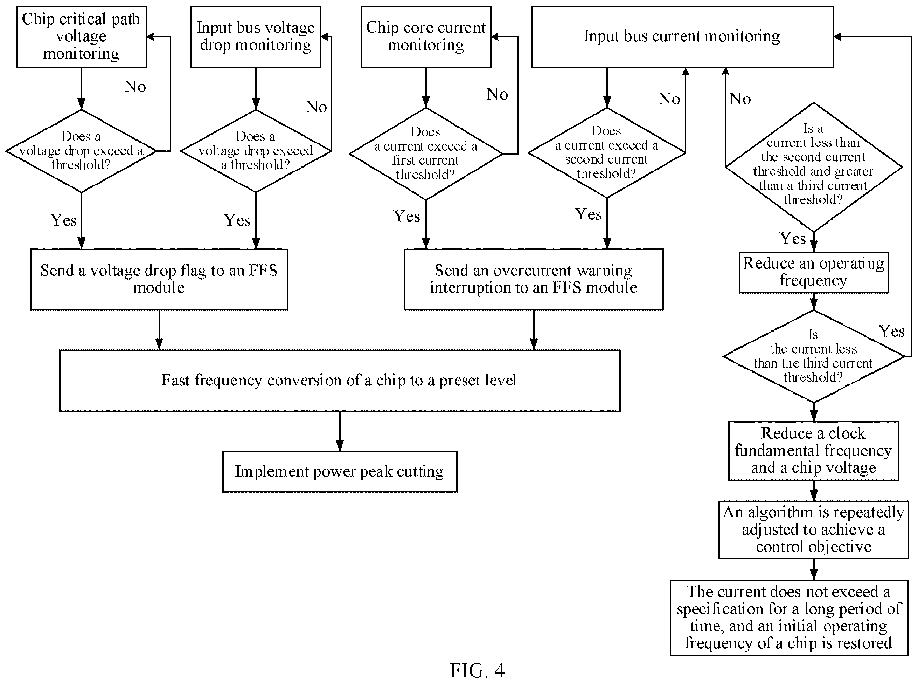

The following further describes, with reference to FIG. 4, the plurality of levels and a level-based power consumption adjustment method shown in FIG. 3 by using an example in which the component is a chip.

It should be noted that the five levels from left to right in the embodiment shown in FIG. 3 correspond to an embodiment shown in FIG. 4, and may be respectively referred to as chip critical path voltage monitoring, input bus voltage drop monitoring, chip core current monitoring, and input bus current monitoring. The input bus current monitoring includes input bus current hardware monitoring and input bus current software monitoring (a rightmost procedure shown in FIG. 4), which respectively correspond to hardware controlling on the current of the input bus and software controlling on the current of the input bus in the embodiment shown in FIG. 3. In other words, in the embodiment shown in FIG. 4, the monitoring from left to right respectively correspond to five levels of control manners: controlling the internal voltage drop of the component, controlling the input bus voltage drop, controlling the core current of the component, hardware controlling on the current of the input bus, and software controlling on the current of the input bus.

Specifically, in the embodiment shown in FIG. 4, in the manner of controlling the internal voltage drop of the component, a chip critical path voltage is monitored. A CPM module is a built-in critical path voltage monitoring module of the chip. When the chip critical path voltage drops below a first voltage threshold (in other words, when the chip critical path voltage is less than the first voltage threshold) because a voltage drop (IR-drop) on the monitored path is excessively large, the CPM module immediately sends a drop flag (drop flag) to an FFS module to implement fast frequency reduction, to reduce power consumption of the chip and ensure that the chip does not fail due to an unsatisfied signal time sequence caused by an excessively low voltage. The signal time sequence includes a waveform time sequence, including setup time, hold time, and the like, for example, rising setup time and hold time of a high level value.

In the manner of controlling the input bus voltage drop, a voltage of an input bus is monitored, in other words, a voltage of an external input bus of the chip is monitored in real time, and a voltage value is monitored and compared with a second voltage threshold via a comparator. When the voltage drops below the second voltage threshold due to excessive load, a power supply voltage drop warning is sensed, and an FFS module is triggered to perform fast frequency conversion to reduce the power consumption of the chip.

In manner of controlling the core current of the component, a core current of the chip is monitored. An overcurrent warning interruption of a multiphase power supply controller may be used. When the core current of the chip exceeds a first current threshold, the controller responds in microseconds and sends an overcurrent warning (Iout_warn) interruption. The interruption is received by the FFS module, and the FFS module reduces a frequency, so that xPU is enabled to respond fast, to reduce the power consumption of the chip. The multiphase power supply controller may be a nuclear power multiphase power supply controller of a processor. This is not specifically limited herein.

In the manner of hardware controlling on the current of the input bus, a current of the input bus is monitored. Current sampling time and a second current threshold may be written into a current sensor in advance. When an actual sampled current exceeds the second current threshold, an overcurrent warning interruption is immediately triggered to the FFS module, to implement fast frequency reduction and power consumption reduction.

In the manner of software controlling on the current of the input bus, software queries a current of the input bus in a polling manner and sets a polling periodicity as an adjustable parameter. A quantity of times that a power supply current of the chip exceeds a specification in one periodicity is counted, where that a power supply current of the chip exceeds a specification means that the current of the input bus is greater than a third current threshold. The power consumption of the chip is adjusted by setting a threshold of the quantity of times and using an algorithm to determine a frequency reduction amplitude and a voltage reduction amplitude of the component. In this way, the chip current does not exceed the specification within a specified time interval. The threshold of the quantity of times is determined based on the specification of a computing device and an actual application requirement. This is not specifically limited herein. Usually, a lower requirement of a device specification on the power consumption of the component indicates a lower threshold of the quantity of times; and a higher requirement of a device specification on the power consumption of the component indicates a higher threshold of the quantity of times.

In some optional implementations, as shown in FIG. 4, when it is detected that the current of the input bus is greater than the third current threshold, an operating frequency of the chip is reduced. Then, the power supply current of the chip is monitored again, and when the power supply current of the chip is greater than the third current threshold again, the operating frequency of the chip is reduced again by reducing a clock fundamental frequency and/or the voltage. The operating frequency of the chip is repeatedly adjusted by using a software algorithm until a control objective is achieved (in other words, the current of the input bus is reduced to be less than the third current threshold).

In some optional implementations, if the current of the input bus is stable and does not exceed the specification for a long period of time, the chip may be restored to a power consumption state before the adjustment, in other words, the operating frequency of the chip is restored to an initial operating frequency. That the current of the input bus is stable and does not exceed the specification for a long period of time means that the current of the input bus is continuously less than a fourth current threshold within preset duration, and the fourth current threshold is less than or equal to the third current threshold. The preset duration needs to be determined based on an actual application requirement. For example, the preset duration may be duration at a 10-second level, a 100-second level, or a minute level. This is not specifically limited herein. In addition, the operating frequency of the chip may be restored by using an algorithm, for example, an artificial intelligence core (artificial intelligence core, AI CORE) frequency restoration algorithm. This is not specifically limited herein.

In this application, the adjustment of the power consumption of the component includes power consumption reduction and power consumption restoration. This ensures normal operation of the component in the computing device from a plurality of aspects, and further improves practicability of the technical solutions.

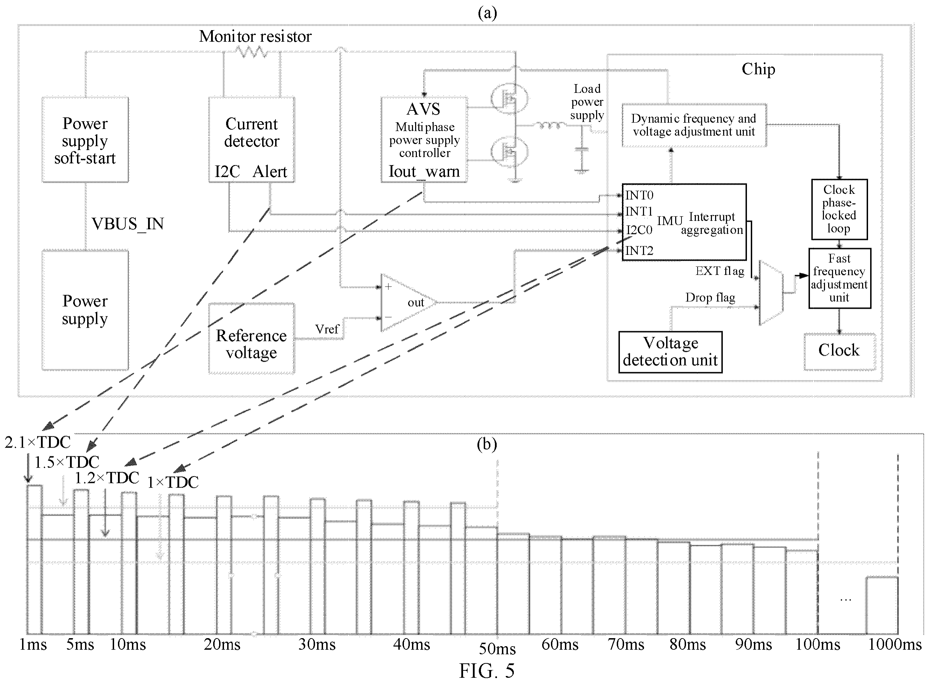

In the following, the example in which the component is the chip is still used to further describe a circuit structure for performing the power consumption adjustment method in this application. FIG. 5 is a diagram of a power consumption adjustment method according to this application.

In an embodiment shown in FIG. 5, (a) in FIG. 5 is an example of a circuit structure for implementing the foregoing functions, and (b) in FIG. 5 reflects response time corresponding to different current thresholds in manners of hardware controlling on a current of an input bus and software controlling on the current of the input bus.

In the example of (a) in FIG. 5, the power supply system is represented as a power supply module (power supply unit, PSU). A current detector and a dynamic frequency and voltage adjustment unit are configured to monitor a current of the input bus, but the current detector corresponds to hardware controlling on the current of the input bus, and the dynamic frequency and voltage adjustment unit corresponds to software controlling on the current of the input bus. A multiphase power supply controller is configured to monitor a core current of a chip. A comparator connected to a reference voltage is configured to monitor a voltage of the input bus. A voltage detection unit is configured to monitor a critical path voltage of the chip.

In the foregoing embodiments, for software controlling on the current of the input bus, an example in which there is one third current threshold (for example, 1.2×TDC) is used. During actual application, alternatively, a plurality of third current thresholds may be set, and thresholds corresponding to the plurality of third current thresholds gradually decrease. For example, in the embodiment shown in (b) in FIG. 5, two third current thresholds are set: 1.2×TDC and 1×TDC. In comparison with setting one third current threshold, the plurality of third current thresholds are set, so that power consumption of the component can be adjusted more smoothly, and further, impact of adjusting the power consumption of the component on service performance is reduced.

In some optional implementations, if the plurality of third current thresholds are set, the thresholds corresponding to the third current thresholds gradually decrease. Correspondingly, in software controlling on the current of the input bus, a frequency reduction amplitude and/or a voltage reduction amplitude corresponding to a determined component may also gradually increase. The frequency reduction amplitude indicates a percentage of a standard operating frequency of the component to which an operating frequency of the component is to be reduced, and the voltage reduction amplitude indicates a percentage of a current voltage to which a voltage of the component is to be reduced.

For example, a second current threshold shown in (b) in FIG. 5 is 1.5×TDC, and the third current thresholds are respectively 1.2×TDC and 1×TDC. When a monitoring result obtained by a power consumption control module indicates that a current of the input bus is less than 1.5×TDC and greater than 1.2×TDC, the component determined by the power consumption control module corresponds to a frequency reduction amplitude 1 and a voltage reduction amplitude 1. When a monitoring result obtained by the power consumption control module indicates that a current of the input bus is less than 1.2×TDC and greater than 1×TDC, the component determined by the power consumption control module corresponds to a frequency reduction amplitude 2 and a voltage reduction amplitude 2.

Optionally, a relationship between the two groups of amplitudes may be that the frequency reduction amplitude 2 is greater than the frequency reduction amplitude 1, and the voltage reduction amplitude 2 is greater than the voltage reduction amplitude 1. In other words, a degree by which the operating frequency of the component is controlled to be reduced based on the frequency reduction amplitude 1 is greater than a degree by which the operating frequency of the component is controlled to be reduced based on the frequency reduction amplitude 2, and a degree by which the voltage of the component is controlled to be reduced based on the voltage reduction amplitude 1 is greater than a degree by which the voltage of the component is controlled to be reduced based on the voltage reduction amplitude 2. Optionally, a relationship between the two groups of amplitudes may be that the frequency reduction amplitude 2 is greater than the frequency reduction amplitude 1, and the voltage reduction amplitude 2 is less than or equal to the voltage reduction amplitude 1. In other words, a degree by which the operating frequency of the component is controlled to be reduced based on the frequency reduction amplitude 1 is greater than a degree by which the operating frequency of the component is controlled to be reduced based on the frequency reduction amplitude 2, and a degree by which the voltage of the component is controlled to be reduced based on the voltage reduction amplitude 1 is slightly greater than or equal to a degree by which the voltage of the component is controlled to be reduced based on the voltage reduction amplitude 2.

Optionally, a relationship between the two groups of amplitudes may be that the frequency reduction amplitude 2 is less than or equal to the frequency reduction amplitude 1, and the voltage reduction amplitude 2 is greater than the voltage reduction amplitude 1. In other words, a degree by which the operating frequency of the component is controlled to be reduced based on the frequency reduction amplitude 1 is slightly greater than or equal to a degree by which the operating frequency of the component is controlled to be reduced based on the frequency reduction amplitude 2, and a degree by which the voltage of the component is controlled to be reduced based on the voltage reduction amplitude 1 is greater than a degree by which the voltage of the component is controlled to be reduced based on the voltage reduction amplitude 2.

In addition, it should be noted that there is a correspondence between the frequency reduction amplitude and the voltage reduction amplitude. Specifically, an operating frequency of the component adjusted based on the frequency reduction amplitude corresponds to a voltage of the component adjusted based on the voltage reduction amplitude, and the correspondence is usually set before delivery of the component.

In this application, for the controlling the current of the input bus, the foregoing multi-level control (including the hardware control and the software control) is implemented, and multi-time specification control is also implemented. As shown in (b) in FIG. 5, response time for the software control is greater than response time for the hardware control. Therefore, when a current value is greater than a higher current threshold (the second current threshold), it indicates that a power supply peak of the power supply system in a computing device is serious, and a fast response is needed, and the hardware control is selected. When a current value is less than a higher current threshold but greater than a lower current threshold (less than the second current threshold and greater than the third current threshold), it indicates that a power supply peak of the power supply system in a computing device is not serious, and refined adjustment may be implemented through the software control.

In addition, it should be further noted that, in the scenario described in the embodiment shown in FIG. 4 that "the current of the input bus is stable and does not exceed the specification for a long period of time, and the chip is restored to a power consumption state before the adjustment", it limits a case in which the current of the input bus is continuously less than the fourth current threshold within preset duration, and the fourth current threshold is less than or equal to the third current threshold. When a plurality of third current thresholds are set, the fourth current threshold should be less than or equal to a third current threshold with a minimum threshold in the plurality of third current thresholds.

In the foregoing descriptions, for current monitoring, the power consumption control module compares an obtained current with a corresponding current threshold. During actual application, the power consumption control module may further determine a power control level strategy based on actually measured power consumption and a corresponding power consumption threshold, and adjust the power consumption of the component according to the power control level strategy.

In other words, the power consumption control module obtains a corresponding current and voltage, and then determines power consumption based on the current and the voltage. Therefore, the consumption is compared with a corresponding power consumption threshold. Correspondingly, the current and the voltage obtained by the power consumption control module include the monitoring objects shown in Table 2. A process in which the power consumption control module determines the power control level strategy and adjusts the power consumption of the component according to the power control level strategy is also similar to the foregoing processes described in the embodiments shown in FIG. 2 to FIG. 5. A difference includes that after obtaining the voltage parameter and the current parameter of the power supply system and/or the component, the power consumption control module further determines the corresponding power consumption. Therefore, details are not described herein again.

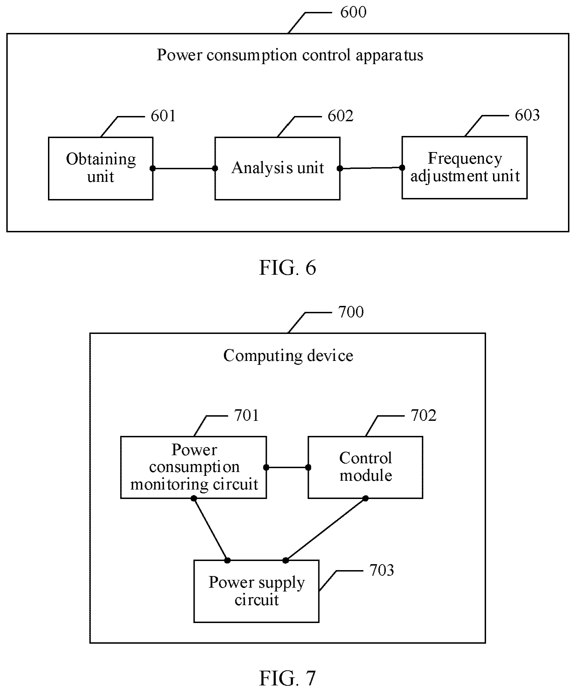

The foregoing describes in detail the power consumption adjustment method provided in this application with reference to FIG. 1 to FIG. 5. The following describes a power consumption control apparatus, a computing device, and a chip provided in this application with reference to FIG. 6 to FIG. 9.

FIG. 6 is a diagram of a structure of a power consumption control apparatus according to this application. As shown in FIG. 6, the power consumption control apparatus 600 includes an obtaining unit 601, an analysis unit 602, and a frequency adjustment unit 603.

The obtaining unit 601 is configured to obtain monitoring results of a power supply system and a component of a computing device, where the monitoring results include a voltage drop parameter of an internal module of the component, a bus voltage drop parameter of a voltage of an input bus in the power supply system, a first bus current parameter of a current of the input bus, and a load power parameter of a core current provided for the component.

The analysis unit 602 is configured to determine a power control level strategy based on the monitoring results, where the power control level strategy is used to adjust power consumption of the component based on the monitoring results of the power system and the component, to cut a power peak and a dynamic power adjustment manner in the power supply system.

The frequency adjustment unit 603 is configured to adjust the power consumption of the component according to the power control level strategy.

It should be understood that the power consumption control apparatus 600 in this embodiment of this application may be implemented by using a central processing unit (central processing unit, CPU), or may be implemented by using an application-specific integrated circuit (application-specific integrated circuit, ASIC), or may be implemented by using a programmable logic device (programmable logic device, PLD). The PLD may be a complex programmable logic device (complex programmable logic device, CPLD), a field programmable gate array (field programmable gate array, FPGA), generic array logic (generic array logic, GAL), a power consumption control unit (data processing unit, DPU), a system-on-chip (system-on-chip, SoC), an artificial intelligence chip, a chip that has a computing capability, or any combination thereof. When the power consumption adjustment methods shown in FIG. 1 to FIG. 4 may also be implemented by using software, the power consumption control apparatus 600 and each module thereof may also be software modules.

In some optional implementations, the voltage drop parameter of the internal module of the component is obtained by an internal voltage monitoring module of the component by monitoring a voltage of the internal module of the component. The analysis unit 602 is specifically configured to: if a voltage parameter of the internal module of the component indicates that the voltage of the internal module of the component is less than a first voltage threshold, determine that the power control level strategy is reducing an operating frequency of the component to a first preset percentage of a standard operating frequency of the component, where the operating frequency of the component is positively correlated with the power consumption of the component.

In some optional implementations, the bus voltage drop parameter is obtained by a bus voltage monitoring module on the input bus in the power supply system by monitoring the voltage of the input bus in the power supply system. The analysis unit 602 is specifically configured to: if the bus voltage drop parameter indicates that the voltage of the input bus in the power supply system is less than a second voltage threshold, determine that the power control level strategy is reducing the operating frequency of the component to a second preset percentage of a current operating frequency of the component.

In some optional implementations, the load power parameter is obtained by a power control chip by detecting the core current of the component. The analysis unit 602 is specifically configured to: if the load power parameter indicates that the core current of the component is greater than a first current threshold, determine that the power control level strategy is reducing the operating frequency of the component to a third preset percentage of the standard operating frequency of the component.

In some optional implementations, the first bus current parameter is obtained by a bus current detection module on the input bus in the power supply system by monitoring the current of the input bus. The analysis unit 602 is specifically configured to: if the first bus current parameter indicates that the current of the input bus is greater than a second current threshold, determine that the power control level strategy includes a hardware control strategy, where the hardware control strategy indicates to reduce the operating frequency of the component to a fourth preset percentage of the standard operating frequency of the component.

In some optional implementations, the obtaining unit 601 is further configured to obtain a second bus current parameter of the current of the input bus, where the second bus current parameter is obtained by a software module by querying the current of the input bus.

The analysis unit 602 is further configured to: if the second bus current parameter indicates that the current of the input bus is greater than a third current threshold, and the power consumption control apparatus 600 enters a software control phase, determine a first frequency reduction amplitude and a first voltage reduction amplitude based on the second bus current parameter. The third current threshold is less than the second current threshold, the first frequency reduction amplitude indicates a percentage of the standard operating frequency of the component to which the operating frequency of the component is to be reduced, and the first voltage reduction amplitude indicates a percentage of a current voltage to which a voltage of the component is to be reduced.

The frequency adjustment unit 603 is further configured to control, based on the first frequency reduction amplitude and the first voltage reduction amplitude, the operating frequency and the voltage of the component to be reduced, to reduce the power consumption of the component.

In some optional implementations, the first bus current parameter is obtained by the software module by querying the current of the input bus. The analysis unit 602 is specifically configured to: if the first bus current parameter indicates that the current of the input bus is greater than a third current threshold, and the power consumption control apparatus 600 enters a software control phase, determine a second frequency reduction amplitude and a second voltage reduction amplitude based on the first bus current parameter, where the second frequency reduction amplitude indicates a percentage of the standard operating frequency of the component to which the operating frequency of the component is to be reduced, and the second voltage reduction amplitude indicates a percentage of a current voltage to which a voltage of the component is to be reduced.

The frequency adjustment unit 603 is specifically configured to control, based on the second frequency reduction amplitude and the second voltage reduction amplitude, the operating frequency and the voltage of the component to be reduced, to reduce the power consumption of the component.

In some optional implementations, the frequency adjustment unit 603 is further configured to: if the current of the input bus is continuously less than a fourth current threshold within preset duration, control the power consumption of the component to restore to power consumption before the reduction, where the fourth current threshold is less than or equal to the third current threshold. The power consumption control apparatus 600 in this embodiment of this application may be corresponding to the method described in embodiments of this application of the present invention, and the foregoing and other operations and/or functions of the units in the power consumption control apparatus 600 are respectively used to implement corresponding procedures of the power consumption control module in the methods in FIG. 1 to FIG. 4. For brevity, details are not described herein again.

This application further provides a computing device. As shown in FIG. 7, FIG. 7 is a diagram of a structure of a computing device according to this application.

As shown in FIG. 7, the computing device 700 includes a power consumption monitoring circuit 701, a control module 702, and a power supply circuit 703. The power supply circuit 703 supplies power to the power consumption monitoring circuit 701 and the control module 702.

The power consumption monitoring circuit 701 is configured to: monitor a power supply system and a component of the computing device; and transmit monitoring results of the power supply system and the component to the control module 702, where the monitoring results include a voltage drop parameter of an internal module of the component, a bus voltage drop parameter of a voltage of an input bus in the power supply system, a first bus current parameter of a current of the input bus and/or a second bus current parameter of the current of the input bus, and a load power parameter of a core current provided for the component.

The control module 702 is configured to: determine a power control level strategy based on the monitoring results, where the power control level strategy is used to adjust power consumption of the component based on the monitoring results of the power system and the component, to cut a power peak and a dynamic power adjustment manner in the power supply system; and adjusts the power consumption of the component according to the power control level strategy.

In other words, the control module 702 is configured to perform operations performed by the power consumption control module in the embodiments shown in FIG. 1 to FIG. 4. Details are not described herein again.

In addition, it should be noted that, corresponding to the embodiment shown in (a) in FIG. 5, the power consumption monitoring circuit 701 corresponds to the current detector, the multiphase power supply controller, the voltage comparator, and the voltage detection unit shown in (a) in FIG. 5. The control module 702 corresponds to the dynamic frequency and voltage adjustment unit and the fast frequency adjustment unit shown in (a) in FIG. 5. The power supply circuit 703 corresponds to the power supply shown in (a) in FIG. 5.

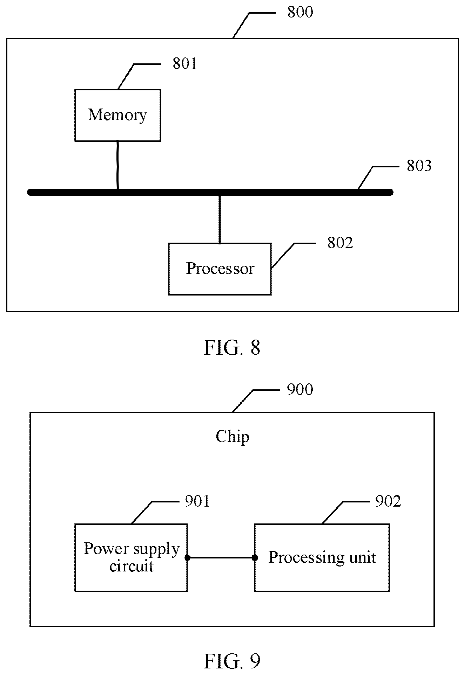

The computing device provided in this application may alternatively have another form. FIG. 8 is a diagram of a structure of a computing device according to this application.

As shown in FIG. 8, the computing device 800 includes a memory 801 and a processor 802, and the memory 801 and the processor 802 communicate with each other through a bus 803. The memory 801 is configured to store instructions or program code. The processor 802 may invoke the instructions or the program code stored in the memory 801 to perform the following operations.

Obtain monitoring results of a power supply system and a component of the computing device, where the monitoring results include a voltage drop parameter of an internal module of the component, a bus voltage drop parameter of a voltage of an input bus in the power supply system, a first bus current parameter of a current of the input bus, and a load power parameter of a core current provided for the component. Determine a power control level strategy based on the monitoring results, where the power control level strategy is used to adjust power consumption of the component based on the monitoring results of the power system and the component, to cut a power peak and a dynamic power adjustment manner in the power supply system. Adjust the power consumption of the component according to the power control level strategy.

It should be understood that, in this embodiment of this application, the processor 802 may be a CPU, or the processor 802 may be another digital signal processor (digital signal processor, DSP), an application-specific integrated circuit (ASIC), a field programmable gate array (FPGA), or another programmable logic device, a discrete gate or a transistor logic device, a discrete hardware component, or the like.

The memory 801 may be a magnetic disk or a hard disk, and provides instructions and data for an SCM controller 801. The memory 801 may further include a non-volatile random access memory. For example, the processor 802 may further store information of a device type. The memory 801 may be a volatile memory or a non-volatile memory, or may include both a volatile memory and a non-volatile memory. The non-volatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The memory may also be a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchlink dynamic random access memory (synchlink DRAM, SLDRAM), or the like, which is not specifically limited herein.

In addition to a data bus, the bus 803 may further include a power bus, a control bus, a status signal bus, and the like. However, for clear description, various types of buses in the figures are marked as the buses 803.

The bus 803 may be a peripheral component interconnect express (Peripheral Component Interconnect Express, PCIe) bus, an extended industry standard architecture (extended industry standard architecture, EISA) bus, a unified bus (unified bus, Ubus or UB), a compute express link (compute express link, CXL), a cache coherent interconnect for accelerators (cache coherent interconnect for accelerators, CCIX), or the like. The bus 803 may be classified into an address bus, a data bus, a control bus, and the like.

It should be understood that the processor 801 in this embodiment of this application may correspond to the power consumption control apparatus 600 in embodiments of this application, and may correspond to a corresponding subject in performing the method in embodiments of this application. In addition, the foregoing and other operations and/or functions of the modules in the power consumption control apparatus 600 are respectively used to implement corresponding procedures of the methods in FIG. 1 to FIG. 4. For brevity, details are not described herein again.

FIG. 9 is a diagram of a structure of a chip according to this application.

As shown in FIG. 9, the chip 900 includes a power supply circuit 901 and a processing unit 902. The power supply circuit 901 supplies power to the processing unit 902. The processing unit 902 is configured to implement the methods shown in FIG. 1 to FIG. 4. Details are not described herein again.

This application further provides a computing device including the chip shown in FIG. 9. The power supply circuit 901 in the chip 900 supplies power to the processing unit 902, and the processing unit 902 is configured to implement the methods shown in FIG. 1 to FIG. 4. Details are not described herein again.

All or some of the foregoing embodiments may be implemented using software, hardware, firmware, or any combination thereof. When the software is used to implement embodiments, all or some of the foregoing embodiments may be implemented in a form of a computer program product. The computer program product includes one or more computer instructions. When the computer program instructions are loaded or executed on a computer, all or some of the procedures or the functions according to embodiments of this application are generated. The computer may be a general-purpose computer, a dedicated computer, a computer network, or another programmable apparatus. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (DSL)) or wireless (for example, infrared, radio, or microwave) manner. The computer-readable storage medium may be any usable medium accessible by a computer, or a data storage device, such as a server or a data center, integrating one or more usable media. The usable medium may be a magnetic medium (for example, a floppy disk, a hard disk, or a magnetic tape), an optical medium (for example, a DVD), or a semiconductor medium. The semiconductor medium may be a solid-state drive (solid-state drive, SSD).

The foregoing descriptions are merely specific implementations of this application of the present invention. Any variation or replacement that may be figured out by a person skilled in the art according to the specific implementations provided in this application of the present invention shall fall within the protection scope of this application of the present invention.

## Claims

1. A power consumption adjustment method, wherein the method is performed by a power consumption control module in a computing device, and comprises:
obtaining monitoring results of a power supply system and a component of the computing device, wherein the monitoring results comprise a voltage drop parameter of an internal module of the component, a bus voltage drop parameter of a voltage of an input bus in the power supply system, a first bus current parameter of a current of the input bus, and a load power parameter of a core current provided for the component;
determining a power control level strategy based on the monitoring results, wherein the power control level strategy is used to adjust power consumption of the component based on the monitoring results of the power system and the component, to cut a power peak and a dynamic power adjustment manner in the power supply system; and
adjusting the power consumption of the component according to the power control level strategy.

2. The method according to claim 1, wherein the voltage drop parameter of the internal module of the component is obtained by an internal voltage monitoring module of the component by monitoring a voltage of the internal module of the component; and
the determining a power control level strategy based on the monitoring results comprises:
if a voltage parameter of the internal module of the component indicates that the voltage of the internal module of the component is less than a first voltage threshold, determining that the power control level strategy is reducing an operating frequency of the component to a first preset percentage of a standard operating frequency of the component, wherein the operating frequency of the component is positively correlated with the power consumption of the component.

3. The method according to claim 1 or 2, wherein the bus voltage drop parameter is obtained by a bus voltage monitoring module on the input bus in the power supply system by monitoring the voltage of the input bus in the power supply system; and
the determining a power control level strategy based on the monitoring results comprises:
if the bus voltage drop parameter indicates that the voltage of the input bus in the power supply system is less than a second voltage threshold, determining that the power control level strategy is reducing the operating frequency of the component to a second preset percentage of a current operating frequency of the component.

4. The method according to any one of claims 1 to 3, wherein the load power parameter is obtained by a power control chip by detecting the core current of the component; and
the determining a power control level strategy based on the monitoring results comprises:
if the load power parameter indicates that the core current of the component is greater than a first current threshold, determining that the power control level strategy is reducing the operating frequency of the component to a third preset percentage of the standard operating frequency of the component.

5. The method according to any one of claims 1 to 4, wherein the first bus current parameter is obtained by a bus current detection module on the input bus in the power supply system by monitoring the current of the input bus; and
the determining a power control level strategy based on the monitoring results comprises:
if the first bus current parameter indicates that the current of the input bus is greater than a second current threshold, determining that the power control level strategy comprises a hardware control strategy, wherein the hardware control strategy indicates to reduce the operating frequency of the component to a fourth preset percentage of the standard operating frequency of the component.

6. The method according to claim 5, wherein after the adjusting the power consumption of the component according to the power control level strategy, the method further comprises:
obtaining a second bus current parameter of the current of the input bus, wherein the second bus current parameter is obtained by a software module by querying the current of the input bus;
if the second bus current parameter indicates that the current of the input bus is greater than a third current threshold, and the power consumption control module enters a software control phase, determining a first frequency reduction amplitude and a first voltage reduction amplitude based on the second bus current parameter, wherein the third current threshold is less than the second current threshold, the first frequency reduction amplitude indicates a percentage of the standard operating frequency of the component to which the operating frequency of the component is to be reduced, and the first voltage reduction amplitude indicates a percentage of a current voltage to which a voltage of the component is to be reduced; and
controlling, based on the first frequency reduction amplitude and the first voltage reduction amplitude, the operating frequency and the voltage of the component to be reduced, to reduce the power consumption of the component.

7. The method according to any one of claims 1 to 4, wherein the first bus current parameter is obtained by a software module by querying the current of the input bus;
the determining a power control level strategy based on the monitoring results comprises:
if the first bus current parameter indicates that the current of the input bus is greater than a third current threshold, and the power consumption control module enters a software control phase, determining a second frequency reduction amplitude and a second voltage reduction amplitude based on the first bus current parameter, wherein the second frequency reduction amplitude indicates a percentage of the standard operating frequency of the component to which the operating frequency of the component is to be reduced, and the second voltage reduction amplitude indicates a percentage of a current voltage to which a voltage of the component is to be reduced; and
the adjusting the power consumption of the component according to the power control level strategy comprises:
controlling, based on the second frequency reduction amplitude and the second voltage reduction amplitude, the operating frequency and the voltage of the component to be reduced, to reduce the power consumption of the component.

8. The method according to claim 6 or 7, wherein after the power consumption of the component is reduced, the method further comprises:
if the current of the input bus is continuously less than a fourth current threshold within preset duration, controlling the power consumption of the component to be restored to power consumption before the reduction, wherein the fourth current threshold is less than or equal to the third current threshold.

9. A power consumption control apparatus, comprising:
an obtaining unit, configured to obtain monitoring results of a power supply system and a component of a computing device, wherein the monitoring results comprise a voltage drop parameter of an internal module of the component, a bus voltage drop parameter of a voltage of an input bus in the power supply system, a first bus current parameter of a current of the input bus, and a load power parameter of a core current provided for the component;
an analysis unit, configured to determine a power control level strategy based on the monitoring results, wherein the power control level strategy is used to adjust power consumption of the component based on the monitoring results of the power system and the component, to cut a power peak and a dynamic power adjustment manner in the power supply system; and
a frequency adjustment unit, configured to adjust the power consumption of the component according to the power control level strategy.

10. The apparatus according to claim 9, wherein the voltage drop parameter of the internal module of the component is obtained by an internal voltage monitoring module of the component by monitoring a voltage of the internal module of the component;
the analysis unit is specifically configured to: if a voltage parameter of the internal module of the component indicates that the voltage of the internal module of the component is less than a first voltage threshold, determine that the power control level strategy is reducing an operating frequency of the component to a first preset percentage of a standard operating frequency of the component, wherein the operating frequency of the component is positively correlated with the power consumption of the component.

11. The apparatus according to claim 9 or 10, wherein the load power parameter is obtained by a power control chip by detecting the core current of the component; and
the analysis unit is specifically configured to: if the load power parameter indicates that the core current of the component is greater than a first current threshold, determine that the power control level strategy is reducing the operating frequency of the component to a third preset percentage of the standard operating frequency of the component.

12. A computing device, comprising: a power consumption monitoring circuit, a control module, and a power supply circuit, wherein
the power supply circuit supplies power to the power consumption monitoring circuit and the control module;
the power consumption monitoring circuit is configured to: monitor a power supply system and a component of the computing device; and transmit monitoring results of the power supply system and the component to the control module, wherein the monitoring results comprise a voltage drop parameter of an internal module of the component, a bus voltage drop parameter of a voltage of an input bus in the power supply system, a first bus current parameter of a current of the input bus, and a load power parameter of a core current provided for the component; and
the control module is configured to:
determine a power control level strategy based on the monitoring results, wherein the power control level strategy is used to adjust power consumption of the component based on the monitoring results of the power system and the component, to cut a power peak and a dynamic power adjustment manner in the power supply system; and
adjust the power consumption of the component according to the power control level strategy.
